# EUROPÄISCHE PATENTANMELDUNG

(11) **EP 4 255 145 A1**
(43) Veröffentlichungstag der Anmeldung: **04.10.2023**
(21) Anmeldenummer: 22165500.4
(22) Anmeldetag: 30.03.2022
(51) Int. Cl.: H05K 13/08

(54) **PARAMETRIEREN EINER ELEKTRONIKFERTIGUNGSLINIE**

(71) Anmelder: Siemens Aktiengesellschaft, 80333 München (DE)
(72) Erfinder: Borwieck, Carsten, 14052 Berlin (DE); Erdmann, Michael, 14822 Borkheide (DE); Hanisch, Michael, 16540 Hohen Neuendorf (DE); Jarchoff, Kay, 13347 Berlin (DE); Müller, Bernd, 16259 Falkenberg (DE); Wittreich, Ulrich, 16727 Velten (DE)
(74) Vertreter: Siemens Patent Attorneys

(57) **Zusammenfassung**

Zusammenfassend betrifft die Erfindung ein Verfahren zum Parametrieren einer Elektronikfertigungslinie (201) auf Basis von Vorrichtungsparametern (P20,...,P40) einer Referenzfertigungslinie (200). Die Elektronikfertigungslinien (200, 201) weisen jeweils zumindest:
- eine Vorrichtung (20) zum Aufbringen von Fügematerial auf ein oder mehrere Bauelementträger (PCB),
- eine Bestückvorrichtung (30) zum Bestücken von elektronischen Bauelementen auf die Bauelementträger (PCB),
- eine Fügevorrichtung (40) zum Fügen der elektronischen Bauelemente an die Bauelementträger (PCB) und
- ein Transportsystem (250), das zum Transportieren der Bauelementträger (PCB) durch die Vorrichtungen (20, 30, 40) ausgebildet ist, auf. Um ein ortsunabhängiges Skalieren von Produktionsvolumen auf mehrere Fertigungslinien zu vereinfachen umfasst das Verfahren die Schritte:
- Parametrieren der Vorrichtungen (20,...,40) der Elektronikfertigungslinie (201) auf Basis der Vorrichtungsparameter (P20,...,P40) der Referenzfertigungslinie (201),
- Ermitteln von Ist-Prozessparameterwerten (ACT) in einem begrenzten Bereich (h) um das Transportsystem (250) der parametrierten Elektronikfertigungslinie (201),
- Ermitteln von Abweichungen (DEV) zwischen den Ist-Prozessparameterwerten (ACT) und Referenz-Prozessparameterwerten (REF), wobei die Referenz-Prozessparameterwerte (REF) in einem begrenzten Bereich (h) um das Transportsystem (250) der Referenzfertigungslinie (200) erfasst wurden. Die Erfindung betrifft weiterhin ein Verfahren zum Herstellen einer Serie von elektronischen Baugruppen (100) sowie eine Elektronikfertigungslinie (200,201).

## Beschreibung

Die Erfindung betrifft ein Verfahren zum Parametrieren einer Elektronikfertigungslinie

Ein derartiges Verfahren kommt beispielsweise bei der Inbetriebnahme einer neuen Elektronikfertigungslinie, oder bei der Einführung einer neuen Serie, die erstmalig auf einer bestehenden Anlage gefertigt werden soll, zum Einsatz. Dies ist insbesondere in Fertigungen für Industrieelektronik, Leistungselektronik und Mikroelektronik der Fall.

Elektronikprodukte werden weltweit gefertigt und unterliegen hier unterschiedlichen Umwelt und Rahmenbedingungen. Soll nun ein Produkt / eine Baugruppe in zwei örtlich voneinander getrennten Fertigungslinien gefertigt werden so stellt dies regelmäßig eine Herausforderung dar. Auch das Inbetriebnehmen von weiteren Fertigungslinien am gleichen Standort für bestehende Produkte ist nicht trivial.

Der Erfindung liegt die Aufgabe zugrunde, ein ortsunabhängiges Skalieren von Produktionsvolumen auf mehrere Fertigungslinien zu vereinfachen.

Diese Aufgabe wird durch ein Verfahren zum Parametrieren einer Elektronikfertigungslinie auf Basis von Vorrichtungsparametern einer Referenzfertigungslinie mit den im Anspruch 1 angegebenen Merkmalen gelöst.

Die Elektronikfertigungslinien weisen dazu jeweils zumindest:
- eine Vorrichtung zum Aufbringen von Fügematerial auf ein oder mehrere Bauelementträger,
- eine Bestückvorrichtung zum Bestücken von elektronischen Bauelementen auf die Bauelementträger,
- eine Fügevorrichtung zum Fügen der elektronischen Bauelemente an die Bauelementträger und
- ein Transportsystem, das zum Transportieren der Bauelementträger durch die Vorrichtungen ausgebildet ist, auf.

Das Parametrieren der Vorrichtungen der Elektronikfertigungslinie wird dabei auf Basis von Vorrichtungsparametern der Referenzfertigungslinie durchgeführt. Handelt es sich um Fertigungslinien mit baugleichen Vorrichtungen, so können die Parameter direkt übernommen werden. Beispielsweise können also Konfigurationsdaten kopiert und für die zu parametrierende Elektronikfertigungslinie und deren Vorrichtungen unmittelbar übernommen werden. Handelt es sich um ähnliche Vorrichtungen oder Vorrichtungen von unterschiedlichen Herstellern so können die einzuhaltenden Prozessparameter in die äquivalenten Datenfeldern der zu parametrierenden Vorrichtungen konfiguriert werden. Dabei kann es sich z.B. um Temperaturangaben, Vorschubgeschwindigkeiten, Bestückkräfte, Lottemperaturen (Fügetemperaturen), ... handeln.

Weiterhin werden Ist-Prozessparameterwerte in einem begrenzten Bereich um das Transportsystem der parametrierten Elektronikfertigungslinie ermittelt. Dadurch wird festgestellt, wie sich die Prozessparameter, die in den Vorrichtungen konfiguriert wurden, tatsächlich in der neuen Elektronikfertigungslinie und vor allem auf die zu fertigenden Baugruppen auswirken.

Der Bereich ist dabei ein begrenzter Bereich um das Transportsystem, in anderen Worten ein Bereich, der regelmäßig durch die Baugruppen bzw. durch die darauf angeordneten Bauelemente durchlaufen wird und in dem die für den tatsächlichen Prozess maßgeblichen Bedingungen vorherrschen. Eine Erfassung von Prozessparametern im Bereich lässt dabei unmittelbare Rückschlüsse auf die Bedingungen zu, die tatsächlich auf die Baugruppen und Bauteile (ein)wirken. Zu den im Bereich auftretenden Parameter und deren Werte zählen unter anderem Temperaturen, Restsauerstoffkonzentrationen, Beschleunigungen, Taktung der Linie, auftretende Kräfte auf die Bauelementträger und Bauelemente und weitere Parameter.

In einem weiteren Schritt werden Abweichungen zwischen den Ist-Prozessparameterwerten und Referenz-Prozessparameterwerten ermittelt, wobei die Referenz-Prozessparameterwerte in einem begrenzten Bereich um das Transportsystem der Referenzfertigungslinie erfasst wurden.

Die Referenzfertigungslinie und ihre Referenz-Prozessparameterwerte stellen dabei den Maßstab der einzuhaltenden Werte dar und die Abweichungen können toleriert werden, wenn sie einen definierbaren Schwellwert nicht überschreiten.

In einer weiteren Ausführungsform umfasst das Verfahren den Schritt Ermitteln von Offset-Werten für die Vorrichtungen der Elektronikfertigungslinie auf Basis der Abweichungen. Insbesondere werden die Offset-Werte ermittelt, wenn die Abweichungen einen jeweiligen Schwellwert überschreiten. Die Schwellwerte können für jeden einzelnen Parameter definiert werden. Die Offset-Werte können dabei je nach Vorrichtung als echter Offset (also von einem definierten Parameter aus) oder als Änderung des Parameterwertes realisiert werden. Die Offset Werte können dabei in einer Fertigungsdokumentation abgespeichert werden. Die Offset-Werte werden dabei so eingestellt, dass die Ist-Prozessparameterwerte der Elektronikfertigungslinie den Referenz-Prozessparameterwerten der Referenzfertigungslinie entsprechen. Sind die Abweichungen zu groß, überschreiten diese also einen zweiten erheblich viel Größeren Schwellwert, so kann davon ausgegangen werden, dass eine Wartungsbedürftigkeit vorliegt oder bei der Inbetriebnahme der Linie ein Fehler passiert ist.

In einer weiteren Ausführungsform werden die Ist-Prozessparameterwerten und/oder die Referenz-Prozessparameterwerte mit einem Prozessparametererfassungssystem, das zum Durchlaufen der Elektronikfertigungslinien auf dem Transportsystem ausgebildet ist. Die Referenz-Prozessparameterwerte in der Referenzfertigungslinie werden dabei vor dem Erfassen der Ist-Prozessparameterwerte erfasst oder zur Verfügung gestellt. Darüber hinaus gibt es keine zeitliche Abhängigkeit, sodass jederzeit, nachdem die Referenz-Prozessparameterwerte bestimmt wurden diese wiederum in einer neu zu parametrierenden Anlage als Referenz verwendet werden können.

In einer weiteren Ausführungsform erstreckt sich der Bereich von maximal 40mm oberhalb einer Transportebene des Transportsystems bis maximal 30mm unterhalb der Transportebene. Insbesondere haben sich Werte von 35 mm oberhalb der Transportebene und 25 mm unterhalb der Transportebene als vorteilhaft erwiesen. Die Transportebene ist dabei die Ebene, die sich dadurch definiert, dass die Bauelementträger auf dem Transportsystem aufliegen und somit die Auflagefläche einen Nullpunkt bzw. die Transportebene definiert.

In einer weiteren Ausführungsform fertigen die Fertigungslinien jeweils elektronische Baugruppen einer Serie von elektronischen Baugruppen, wobei zumindest eine Baugruppe der Serie bereits auf der Referenzfertigungslinie gefertigt wurde. Eine Serie ist dabei als eine Anzahl von gleichartigen elektronischen Baugruppen definiert. Gleichartig kann dabei z. B. identisch hinsichtlich der "bill of materials" oder geringfügiger Abweichungen von einzelnen Bauelementen bei gleichem Layout sein.

Das Verfahren ist auch für ähnliche Baugruppen anwendbar, insbesondere bei unterschiedlichen Layouts mit Ähnlichen Bauelementen (also gleiche Leistungsklasse), hier kann es nach einem einstellen von Offset-Werten aber noch notwendig sein, entsprechende Qualitätsuntersuchungen durchzuführen und die Offset-Werte erneut anzupassen.

In einer weiteren Ausführungsform werden die Referenz-Prozessparameterwerte erfasst, nachdem die zumindest eine Baugruppe auf der Referenzfertigungslinie gefertigt wurde. Dabei können Qualitätsanforderungen an die Baugruppen überprüft werden und wenn die Bestimmungen erfüllt wurden, können die Referenz-Prozessparameterwerte freigegeben und für weitere Elektronikfertigungslinien verwendet werden.

In einer weiteren Ausführungsform umfassen die Referenz-Prozessparameterwerte zumindest eine Restsauerstoffkonzentration und/oder eine Temperatur im Bereich um das Transportsystem der Referenzfertigungslinie. Das Erfassen der Referenz-Prozessparameterwerte, insbesondere der Restsauerstoffkonzentration und/oder der Temperatur im Bereich hat den großen Vorteil, dass so eine unmittelbar auf die Baugruppen einwirkenden Prozessbedingungen erfasst werden können und dementsprechend auch auf das zu parametrierende System übertragen werden können.

In einer weiteren Ausführungsform umfassen die Referenz-Prozessparameterwerte zumindest einen Beschleunigungsverlauf und/oder einen Kraftverlauf, der auf die Bauelementträger bzw. Baugruppen einwirkt, die eine Referenzfertigungslinie durchlaufen. Derartige Kraft- bzw. Beschleunigungsverläufe können beispielsweise mit einem Prozessparametererfassungssystem, das zum Durchlaufen der Referenzfertigungslinie ausgebildet ist, erfasst werden. Unter dem Kraftverlauf werden beispielsweise Bestückkräfte oder weitere Kräfte auf die Bauelemente und/oder die Bauelementträger beim Fügen verstanden. Unter dem Beschleunigungsverlauf sind insbesondere die Beschleunigungen gemeint, die durch das Transportsystem bzw. einzelne Prozessschritte auf die Bauelementträger bzw. die dann fertig gestellten Baugruppen einwirken.

In einer weiteren Ausführungsform werden beim Ermitteln der Abweichungen auch Abweichungen zwischen Umgebungsbedingungen, insbesondere Temperatur, Luftfeuchtigkeit und Luftdruck im Umfeld der Fertigungslinien berücksichtigt. In einer einfachen Ausführungsform kann ein Prozessparametererfassungssystem, nachdem es die Fertigungslinie durchlaufen ist, noch für eine Weile im Umfeld der Referenzfertigungslinie gelagert werden, um die Umgebungsparameter zu ermitteln. Es ist ebenso denkbar, dass Umgebungsparameter mit separaten Messmitteln erfasst werden. Das Umfeld ist dabei so definiert, dass im Umfeld die direkt auf die Fertigungslinien einwirkenden Umgebungsbedingungen herrschen. Im Regelfall dehnt sich das Umfeld nur wenige Meter um die Fertigungslinien aus.

In einer weiteren Ausführungsform wird beim Ermitteln der Ist-Prozessparameterwerte und beim Ermitteln der Referenz-Prozessparameterwerte dasselbe Prozessparametererfassungssystem eingesetzt. Dies stellt sicher, dass Messungenauigkeiten, die durch Verwendung von unterschiedlichen Prozessparametererfassungssystemen auf die Parametrierung Einfluss nehmen können, eliminiert werden können. So kann beispielsweise ein Techniker das Prozessparametererfassungssystemen mit den darauf gespeicherten Referenz-Prozessparameterwerten zur Inbetriebnahme der zu parametrierenden Fertigungslinie verwenden und direkt die Abweichungen erhalten und Offset-Werte einstellen.

In einer weiteren Ausführungsform werden beim Ermitteln der Ist-Prozessparameterwerte und beim Ermitteln der Referenz-Prozessparameterwerte zwei unter den gleichen, definierbaren Umgebungsbedingungen (z.B. Normalbedingungen) kalibrierte Prozessparametererfassungssysteme eingesetzt. So müssen die verwendeten Prozessparametererfassungssysteme nicht zwangsläufig am selben Ort kalibriert werden oder verschickt werden, sondern können in unmittelbarer Nähe der zu parametrierenden Elektronikfertigungslinie kalibriert werden. Es ist ebenso denkbar, dass Prozessparameterwerte auf Basis der Umgebungsbedingungen bei der Kalibrierung gewichtet werden.

In einer weiteren Ausführungsform wird beim Ermitteln der Referenz-Prozessparameterwerte ein Kalibrierdatensatz für das Prozessparametererfassungssystem ermittelt. Der Kalibrierdatensatz umfasst dabei die Umgebungsbedingungen unter denen die Referenz-Prozessparameterwerte erfasst wurden, sowie Kalibrierdaten der Sensoren des Prozessparametererfassungssystems. So können also beispielsweise Umgebungsbedingungen vor dem Ermitteln der Referenz-Prozessparameterwerte abgespeichert werden, um später die digitalen Daten ohne Transport der Prozessparametererfassungssysteme an einem anderen Standort verwenden zu können.

Die Aufgabe wird weiterhin durch ein Verfahren zum Herstellen einer Serie von elektronischen Baugruppen gelöst. Die Serie von elektronischen Baugruppen wird dabei auf einer Fertigungslinie gefertigt, wobei die Fertigungslinie durch ein erfindungsgemäßes Verfahren parametriert wurde. Das heißt, es werden entsprechende Prozessparameter auf einer Referenzfertigungslinie ermittelt und an die Fertigungslinie übertragen. Es werden weiterhin Abweichungen ermittelt, um sicherzustellen, dass die Serie der elektronischen Baugruppe unter hinreichend gleichen Bedingungen auf beiden Fertigungslinien produziert werden können. Dies vereinfacht das Übertragen von Fertigungslinien an andere Standorte, wobei Qualitätsanforderungen an die einzelnen Produkte, also definierte elektronische Baugruppen, bestehen bleiben können. Auch das Skalieren der Elektronikfertigung ist so einfacher und effizienter möglich.

Die Aufgabe wird weiterhin durch eine Elektronikfertigungslinie gelöst, die zum Durchführen des erfindungsgemäßen Verfahrens ausgebildet ist. Dazu weist die Elektronikfertigungslinie zumindest eine Vorrichtung zum Aufbringen von Fügematerial auf Bauelementträger auf. Weiterhin eine Bestückvorrichtung zum Bestücken von elektronischen Bauelementen auf die Bauelementträger, eine Fügevorrichtung zum Fügen der elektronischen Bauelemente an die Bauelementträger sowie ein Transportsystem, das zum Transportieren der Bauelementträger durch die Vorrichtungen ausgebildet ist. Weiterhin weist die Elektronikfertigungslinie eine Schnittstelleneinheit auf, die zum Empfangen von Referenz-Prozessparameterwerten ausgebildet ist. Die Schnittstelleneinheit kann dabei als eine Industriesteuerung mit industriellen Kommunikationsschnittstellen ausgebildet sein. Die Schnittstelleneinheit kann aber auch als eine Edge Box ausgebildet sein, die dediziert für die Parametrierung und Überwachung der Prozessparameter ausgebildet ist und beispielsweise mit einer Industriesteuerung der Elektronikfertigungslinie bzw. der einzelnen Vorrichtungen kommuniziert.

In einer weiteren Ausführungsform ist die Schnittstelleneinheit zum Ermitteln von Abweichungen und/oder Offset-Werten ausgebildet. Die Abweichungen werden dabei aus den Referenz-Prozessparameterwerten und den Ist-Prozessparameterwerten ermittelt. Die Offset-Werte können dabei aus den Abweichungen abgeleitet werden.

Im Folgenden wird die Erfindung anhand der in den Figuren dargestellten Ausführungsbeispiele näher beschrieben und erläutert. Es zeigen:
- FIG 1: schematisch eine Referenzfertigungslinie bzw. eine Elektronikfertigungslinie,
- FIG 2: eine Elektronikfertigungslinie mit Vorrichtungsparametern,
- FIG 3: eine Verarbeitung der Ist- und Referenz-Prozessparameter,
- FIG 4: einen schematischen Querschnitt durch ein Transportsystem,
- FIG 5: schematisch ein Prozessparametererfassungssystem auf einem Transportsystem und
- FIG 6: schematisch eine Fügevorrichtung mit Bereich.

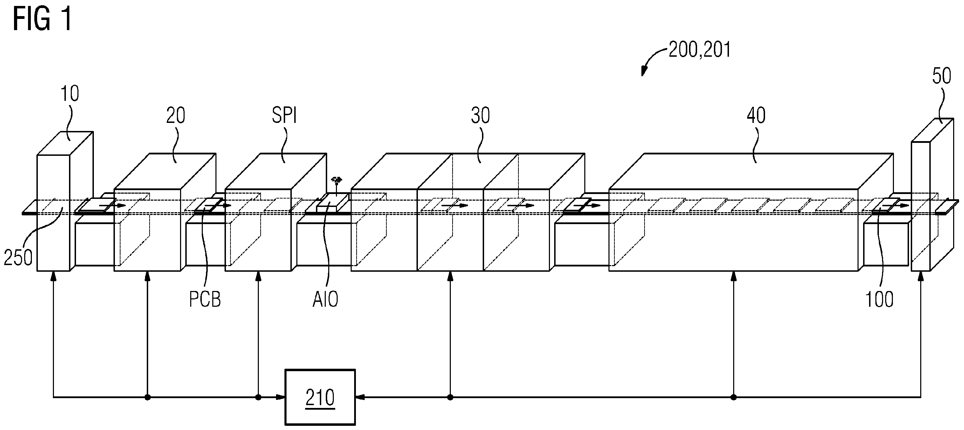

FIG 1 zeigt schematisch eine Elektronikfertigungslinie 200, 201, für eine Referenzfertigungslinie 200 bzw. eine Elektronikfertigungslinie 201 stehen. Im Folgenden werden die Bestandteile der Referenzfertigungslinie 200 beschrieben, wobei diese Bestandteile auch ganz oder teilweise in der Elektronikfertigungslinie 201 zum Einsatz kommen können. Die Referenzfertigungslinie 200 weist dabei Vorrichtungen 10,...,50 auf. Dabei u. a. eine Bereitstellungsvorrichtung 10, die zum Bereitstellen von Bauelementträgern PCB, also beispielsweise Substratmaterialien oder Leiterplatten geeignet ist. Weiterhin ist ein Transportsystem 250 gezeigt, das zum Transport der Bauelementträger PCB durch die Referenzfertigungslinie 200 ausgebildet ist. Eine Vorrichtung 20 zum Aufbringen von Fügematerial kann beispielsweise als ein Lotpasten-Drucker oder Lotpasten-Dispenser ausgebildet sein. Auch Sinterpasten können hier aufgebracht werden. Ein oder mehrere Bestückvorrichtungen 30 bestücken Bauteile, beispielsweise SMD-Bauteile, auf die mit Fügematerialien versehenen Bauelementträger PCB. Eine Fügevorrichtung 40 stellt die Fügeverbindungen zwischen den Bauelementen und den Bauelementträgern PCB über die Fügematerialien fertig. Hier kann es sich beispielsweise um einen Reflow-Ofen oder eine Sinteranlage handeln. Am Ende der Referenzfertigungslinie 200 ist eine Sammelvorrichtung 50 zu sehen, die die hergestellten Baugruppen 100 sammelt. Eine Schnittstelleneinheit 210 steht in Kommunikationsverbindung mit den Vorrichtungen 10,...,50 der Referenzfertigungslinie 200 und kann dabei zum Ermitteln und/oder Ausgeben von Prozessparametern bzw. Vorrichtungsparametern ausgestaltet sein. Die Elektronikfertigungslinie 201 ist dabei genauso aufgebaut wie die Referenzfertigungslinie 200, wobei einzelne Vorrichtungen von denselben Herstellern, unterschiedlichen Herstellern aber mit ähnlichen Vorrichtungsparametern oder unterschiedlichen Herstellern stammen können. Idealerweise sind die Vorrichtungen der Elektronikfertigungslinie 201 und die der Referenzfertigungslinie 200 baugleich. Wenn sich die Vorrichtungen unterscheiden, so kann auf Basis der technischen Daten der Vorrichtungen (maximale Heizleistung, ...) entweder Parameter als initiale Parameter direkt übernommen werden oder angepasste Parameter erstellt werden.

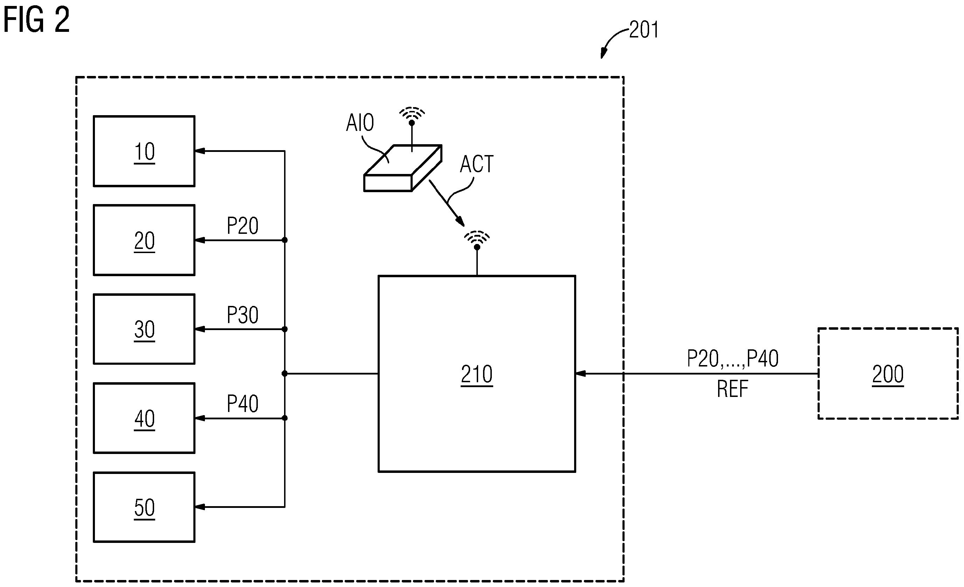

FIG 2 zeigt schematisch eine zu parametrierende Elektronikfertigungslinie 201, die mit Vorrichtungsparametern P20,...,P40 parametriert, mit Referenz-Prozessparameterwerten REF einer Referenzfertigungslinie 200 überprüft wird. Die Referenz-Prozessparameterwerte REF sowie die Prozessparameterwerte werden dabei einer Schnittstelleneinheit 210 zur Verfügung gestellt, die beispielsweise als eine Industriesteuerung ausgebildet ist und zum Parametrieren der einzelnen Vorrichtungen 10,...,50 dienen kann. Im vorliegenden Fall werden Parameter P20 für die Vorrichtung 20 zum Aufbringen von Fügematerial, Parameter P30 für die Bestückvorrichtung 30 und Parameter P40 für die Fügevorrichtung 40 zur Verfügung gestellt. Sind die Vorrichtungen 20,...,40 dann parametriert, so kann ein Prozessparametererfassungssystem AIO auf dem Transportsystem 250 durch die Elektronikfertigungslinie 201 transportiert werden und dabei Ist-Prozessparameterwerte ACT erfassen. Die Ist-Prozessparameterwerte ACT können dabei über eine drahtlose Verbindung zwischen dem Prozessparametererfassungssystem AIO und beispielsweise der Schnittstelleneinheit 210 und/oder einem Inbetriebnahme-Rechner (Laptop, Tablet, Smartphone, jeweils mit einem Programm / einer App) übertragen werden.

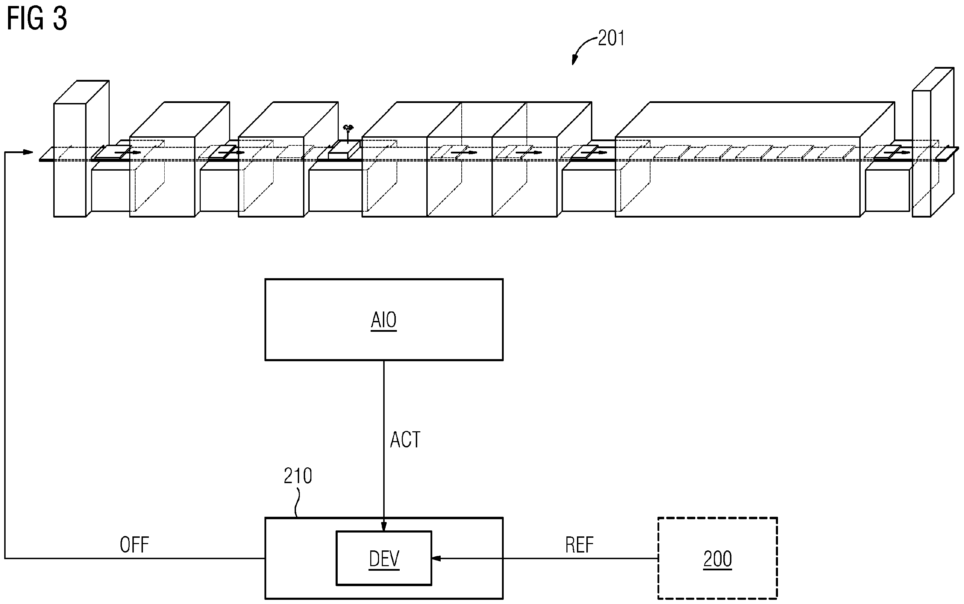

Figur 3 zeigt schematisch, wie aus den Ist-Prozessparameterwerten ACT, der mit den Prozessparametern P20,...,P40 parametrierten Elektronikfertigungslinie 201 und den Referenz-Prozessparameterwerten REF der Referenzfertigungslinie 201 in der Schnittstelleneinheit 210 Abweichungen DEV ermittelt werden. Auf Basis der Abweichungen können dann Offset-Werte für die Elektronikfertigungslinie 201 und ihre Vorrichtungen 20,...,40 bestimmt werden, damit die Fertigungsbedingungen denen der Referenzfertigungslinie entsprechen. Sollte das Einstellen der Offset-Werte keine zufriedenstellenden Ergebnisse liefern, so kann der Prozess wiederholt werden, oder bei gravierenden Abweichungen die Anlage überprüft werden (z.B. Defekte wie eine mangelnde Abdichtung, sodass Prozessgas entweicht).

In anderen Worten ist in FIG 3 zu sehen, wie für eine zu parametrierende Elektronikfertigungslinie 201 aus den Ist-Prozessparameterwerten ACT und den Referenz-Prozessparameterwerten REF einer Referenzfertigungslinie 200 Abweichungen DEV generiert werden, auf deren Basis die Schnittstelleneinheit 210 Offset-Werte OFF für die Elektronikfertigungslinie 201 erstellt. Diese Offset-Werte OFF können unmittelbar durch die Schnittstelleneinheit 210 in der Elektronikfertigungslinie 201 eingestellt werden, alternativ oder ergänzend ist es möglich, dass einzelne Vorrichtungen (nicht gezeigt) der Elektronikfertigungslinie 201 eigene Steuereinrichtungen haben, an die die Offset-Werte OFF kommuniziert werden und die dann über die Steuereinrichtung der jeweiligen Vorrichtung in den Vorrichtungen selbst eingestellt werden können. Es ist denkbar, dass einzelne Vorrichtungen Steuereinrichtungen aufweisen, die für mehrere Vorrichtungen die Offset-Werte OFF verwalten.

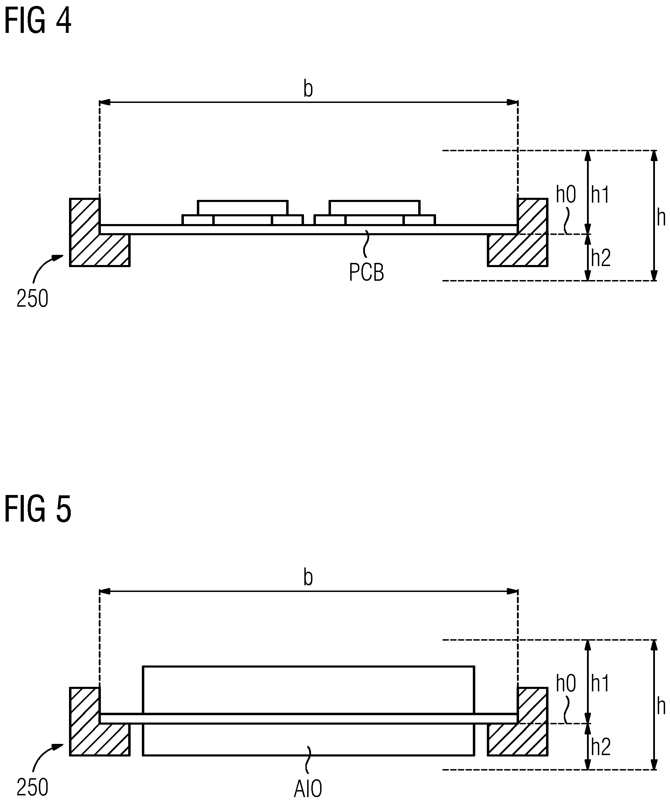

FIG 4 zeigt einen schematischen Querschnitt durch das in FIG 1 gezeigte Transportsystem 250 der Elektronikfertigungslinien 200, 201. Das Transportsystem 250 kann z.B. als ein kettenbasiertes Transportsystem ausgebildet sein, das die Bauelementträger PCB z. B. mit einer Klemmung durch die Elektronikfertigungslinie 200, 201 transportiert. Das Transportsystem 250 ist dabei in der Lage in der Breite b verstellt zu werden, sodass die unterschiedlichen Bauelementträger PCB sicher transportiert werden können. Weiterhin zu sehen ist eine Transportebene h0, die sich aus der Auflage des Transportsystems 250 ergibt, auf der die Bauelementträger PCB aufliegen. Ein Bereich h um die Transportebene herum ist ebenso definiert wie ein Bereich h1 oberhalb der Transportebene h0 sowie ein Bereich h2 unterhalb der Transportebene h0. Für den Bereich h1 oberhalb des Transportsystems 250 haben sich Werte von maximal 35 mm und für den Bereich h2 unterhalb von maximal 25 mm als vorteilhaft erwiesen, da diese in gängigen Elektronikfertigungslinien 200, 201 und mit gängigen bestückten Bauelementträgern eingehalten bzw. durchfahren werden. So kann davon ausgegangen werden, dass ein Messwert, der im Bereich h erfasst wird, die Bedingungen bzw. die Prozessparameter darstellt, wie sie tatsächlich auf einen Bauelementträger PCB einwirken. Der Bereich h ist dabei in seiner breite auf die maximal durch das Transportsystem 250 bereitstellbare Transportbreite b begrenzt. Beste Messwerte ergeben sich innerhalb des Bereiches h, an den Orten, wo im Durchschnitt die meisten Bauteile passieren. Dies kann zum Beispiel bezüglich der Breite b mittig und von 1 bis 5mm oberhalb der Transportebene h0 sein. Ebenso können mehrere Messpunkte über die Breite b verteilt sein.

FIG 5 zeigt schematisch ein Prozessparametererfassungssystem AIO, das auf dem Transportsystem 250 transportiert wird. Der Bereich h und die Breite b ist analog zu FIG 4 angegeben. Zu sehen ist auch, dass das Prozessparametererfassungssystem AIO nicht zwangsläufig den kompletten Bereich h ausfüllen muss. Wenn das Prozessparametererfassungssystem AIO den Bereich h durchfährt, so kann ein Profil der Prozessparameterwerte über die durchfahrene Strecke erstellt werden, indem an mehreren Punkten oder (quasi-)kontinuierlich, z. B. mit einer geeigneten Abtastfrequenz, Prozessparameterwerte erfasst werden.

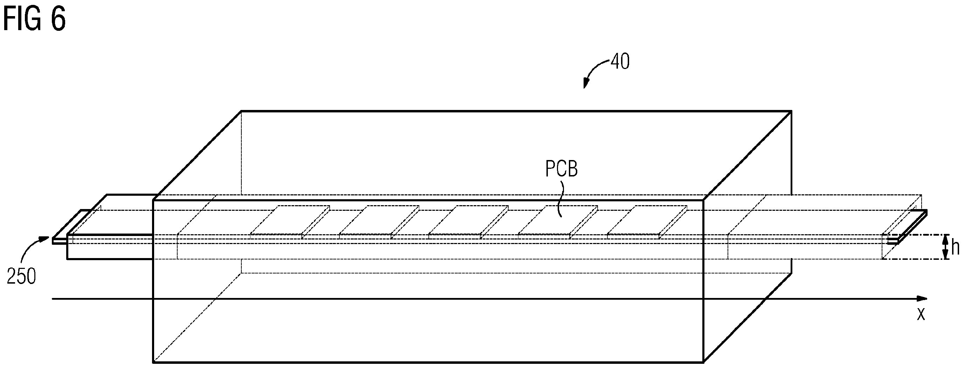

FIG 6 zeigt schematisch eine Fügevorrichtung 40, wie sie in einer Referenzfertigungslinie 200 und einer Fertigungslinie 201 zum Einsatz kommen kann. Gezeigt ist ein Ausschnitt des Transportsystems 250 und eine graphische Darstellung wie sich der Bereich h entlang der Bewegungsrichtung x durch die Fügevorrichtung 40 erstreckt. Der Bereich h bildet so einen virtuellen Tunnel um das Transportsystem, in dem die Ist-Prozessparameterwerte ACT den Referenz-Prozessparameterwerten REF entsprechen sollen. Der Bereich h ist dabei immer innerhalb der jeweiligen Vorrichtung 10,...,50 außer in Abschnitten des Transportsystems 250, die zwischen, vor oder nach den jeweiligen Vorrichtungen angeordnet sind.

Zusammenfassend betrifft die Erfindung ein Verfahren zum Parametrieren einer Elektronikfertigungslinie (201) auf Basis von Vorrichtungsparametern (P20,...,P40) einer Referenzfertigungslinie (200). Die Elektronikfertigungslinien (200, 201) weisen jeweils zumindest:
- eine Vorrichtung (20) zum Aufbringen von Fügematerial auf ein oder mehrere Bauelementträger (PCB),
- eine Bestückvorrichtung (30) zum Bestücken von elektronischen Bauelementen auf die Bauelementträger (PCB),
- eine Fügevorrichtung (40) zum Fügen der elektronischen Bauelemente an die Bauelementträger (PCB) und
- ein Transportsystem (250), das zum Transportieren der Bauelementträger (PCB) durch die Vorrichtungen (20, 30, 40) ausgebildet ist, auf. Um ein ortsunabhängiges Skalieren von Produktionsvolumen auf mehrere Fertigungslinien zu vereinfachen umfasst das Verfahren die Schritte:
- Parametrieren der Vorrichtungen (20,...,40) der Elektronikfertigungslinie (201) auf Basis der Vorrichtungsparameter (P20,...,P40) der Referenzfertigungslinie (201),
- Ermitteln von Ist-Prozessparameterwerten (ACT) in einem begrenzten Bereich (h) um das Transportsystem (250) der parametrierten Elektronikfertigungslinie (201),
- Ermitteln von Abweichungen (DEV) zwischen den Ist-Prozessparameterwerten (ACT) und Referenz-Prozessparameterwerten (REF), wobei die Referenz-Prozessparameterwerte (REF) in einem begrenzten Bereich (h) um das Transportsystem (250) der Referenzfertigungslinie (200) erfasst wurden. Die Erfindung betrifft weiterhin ein Verfahren zum Herstellen einer Serie von elektronischen Baugruppen (100) sowie eine Elektronikfertigungslinie (200,201).

### Bezugszeichen

- 100: elektronische Baugruppen
- PCB: Bauelementträger
- 200: Referenzfertigungslinie
- 201: Elektronikfertigungslinie
- 210: Schnittstelleneinheit

- 10: Bereitstellungsvorrichtung
- 20: Vorrichtung zum Aufbringen von Fügematerial
- 30: Bestückvorrichtung
- 40: Fügevorrichtung
- 50: Sammelvorrichtung
- P20,...,P40: Vorrichtungsparameter

- 250: Transportsystem
- h0: Transportebene
- h: Bereich
- h1, h2: Bereich ober/unterhalb der Transportebene

- SPI: Inspektionsvorrichtung
- REF: Referenz-Prozessparameterwerte
- ACT: Ist-Prozessparameterwerte
- DEV: Abweichungen
- OFF: Offset-Werte
- AIO: Prozessparametererfassungssystem

## Patentansprüche

1. Verfahren zum Parametrieren einer Elektronikfertigungslinie (201) auf Basis von Vorrichtungsparametern (P20,...,P40) einer Referenzfertigungslinie (200),
wobei die Elektronikfertigungslinien (200, 201) jeweils zumindest:
- eine Vorrichtung (20) zum Aufbringen von Fügematerial auf ein oder mehrere Bauelementträger (PCB),
- eine Bestückvorrichtung (30) zum Bestücken von elektronischen Bauelementen auf die Bauelementträger (PCB),
- eine Fügevorrichtung (40) zum Fügen der elektronischen Bauelemente an die Bauelementträger (PCB) und
- ein Transportsystem (250), das zum Transportieren der Bauelementträger (PCB) durch die Vorrichtungen (20, 30, 40) ausgebildet ist, aufweisen,
**umfassend die Schritte:**
- Parametrieren der Vorrichtungen (20,...,40) der Elektronikfertigungslinie (201) auf Basis der Vorrichtungsparameter (P20,...,P40) der Referenzfertigungslinie (201),
- Ermitteln von Ist-Prozessparameterwerten (ACT) in einem begrenzten Bereich (h) um das Transportsystem (250) der parametrierten Elektronikfertigungslinie (201),
- Ermitteln von Abweichungen (DEV) zwischen den Ist-Prozessparameterwerten (ACT) und Referenz-Prozessparameterwerten (REF), wobei die Referenz-Prozessparameterwerte (REF) in einem begrenzten Bereich (h) um das Transportsystem (250) der Referenzfertigungslinie (200) erfasst wurden.

2. Verfahren nach Anspruch 1, umfassend den Schritt:
- Ermitteln von Offset-Werten (OFF) für die Vorrichtungen (20,...,40) auf Basis der Abweichungen (DEV).

3. Verfahren nach Anspruch 1 oder 2, wobei die Ist-Prozessparameterwerte (ACT) und/oder die Referenz-Prozessparameterwerte (REF) mit einem Prozessparametererfassungssystem (AIO) erfasst werden und/oder wurden, das zum Durchlaufen der Elektronikfertigungslinien (200, 201) auf dem Transportsystem (250) ausgebildet ist.

4. Verfahren nach einem der vorhergehenden Ansprüche, wobei sich der Bereich (h) von maximal 40mm oberhalb einer Transportebene (h0) des Transportsystems (250) bis maximal 30mm unterhalb der Transportebene (h0) erstreckt.

5. Verfahren nach einem der vorhergehenden Ansprüche, wobei die Fertigungslinien (200, 201) jeweils elektronische Baugruppen (100) einer Serie (S100) fertigen und wobei zumindest eine Baugruppe (100) der Serie (S100) auf der Referenzfertigungslinie (200) gefertigt wurde.

6. Verfahren nach Anspruch 5, wobei die Referenz-Prozessparameterwerte (REF) erfasst werden, nachdem die zumindest eine Baugruppe (100) auf der Referenzfertigungslinie (200) gefertigt wurde.

7. Verfahren nach einem der vorhergehenden Ansprüche, wobei die Referenz-Prozessparameterwerte (REF) zumindest eine Restsauerstoffkonzentration und/oder eine Temperatur, jeweils im Bereich (h) um das Transportsystem (250) der Referenzfertigungslinie (200), umfassen.

8. Verfahren nach einem der vorhergehenden Ansprüche, wobei die Referenz-Prozessparameterwerte (REF) zumindest einen Beschleunigungsverlauf und/oder einen Kraftverlauf umfassen, der auf die Bauelementträger (PCB) bzw. Baugruppen (100) beim Durchlaufen der Referenzfertigungslinie (200) einwirkt.

9. Verfahren nach einem der vorhergehenden Ansprüche, wobei beim Ermitteln von Abweichungen (DEV) auch Abweichungen zwischen Umgebungsbedingungen, insbesondere Temperatur, Luftfeuchtigkeit und Luftdruck der Fertigungslinien (200, 201) ermittelt werden.

10. Verfahren nach einem der vorhergehenden Ansprüche, wobei beim Ermitteln der Ist-Prozessparameterwerte (ACT) und der Referenz-Prozessparameterwerte (REF) dasselbe Prozessparametererfassungssystem (AIO) eingesetzt wird.

11. Verfahren nach einem der vorhergehenden Ansprüche, wobei beim Ermitteln der Ist-Prozessparameterwerte (ACT) und der Referenz-Prozessparameterwerte (REF) zwei unter gleichen Umgebungsbedingungen kalibrierte Prozessparametererfassungssysteme (AIO) eingesetzt werden.

12. Verfahren nach einem der vorhergehenden Ansprüche, wobei beim Ermitteln der Referenz-Prozessparameterwerte (REF) für ein Kalibrierdatensatz für das Prozessparametererfassungssystem (AIO) ermittelt wird. <übertragen an andere Standorte>

13. Verfahren zum Herstellen einer Serie von elektronischen Baugruppen (100) auf einer Fertigungslinie (201), die durch ein Verfahren nach einem der vorhergehenden Ansprüche parametriert wurde.

14. Elektronikfertigungslinie (200,201) zum Durchführen eines Verfahrens nach einem der Ansprüche 1 bis 12, aufweisend
- eine Vorrichtung (20) zum Aufbringen von Fügematerial auf Bauelementträger (PCB),
- eine Bestückvorrichtung (30) zum Bestücken von elektronischen Bauelementen auf die Bauelementträger (PCB),
- eine Fügevorrichtung (40) zum Fügen der elektronischen Bauelemente an die Bauelementträger (PCB),
- ein Transportsystem (250), das zum Transportieren der Bauelementträger (PCB) durch die Vorrichtungen (20, 30, 40) ausgebildet ist und
- zumindest eine Schnittstelleneinheit (210), die zum Empfangen von Referenz-Prozessparameterwerten (REF) ausgebildet ist.

15. Elektronikfertigungslinie (200) nach Anspruch 14, wobei die Schnittstelleneinheit (210) zum Ermitteln von Abweichungen (DEV) und/oder Offset-Werten (OFF) ausgebildet ist.
